(19) Europäisches Patentamt / European Patent Office / Office européen des brevets

(11) EP 2 775 621 B1

(12) **EUROPEAN PATENT SPECIFICATION**

(45) Date of publication and mention
of the grant of the patent:
**15.08.2018 Bulletin 2018/33**

(51) Int Cl.:
*H03K 17/06* (2006.01)  *H02M 3/07* (2006.01)

(21) Application number: **13158227.2**

(22) Date of filing: **07.03.2013**

(54) **A Dickson charge pump circuit**

Schaltung für Dickson-Ladungspumpe

Circuit de pompe de charge Dickson

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**10.09.2014 Bulletin 2014/37**

(73) Proprietor: **Rohm Co., Ltd.
Kyoto-shi, Kyoto 615-8585 (JP)**

(72) Inventor: **Joita, Adrian
Ukyo-ku, Kyoto 615-8585 (JP)**

(74) Representative: **Isarpatent
Patent- und Rechtsanwälte Behnisch Barth
Charles
Hassa Peckmann & Partner mbB
Friedrichstrasse 31
80801 München (DE)**

(56) References cited:
**US-A1- 2009 160 532    US-A1- 2013 026 829**

**Description**

The invention relates to a high side switch comprising a Dickson charge pump circuit with increased efficiency.

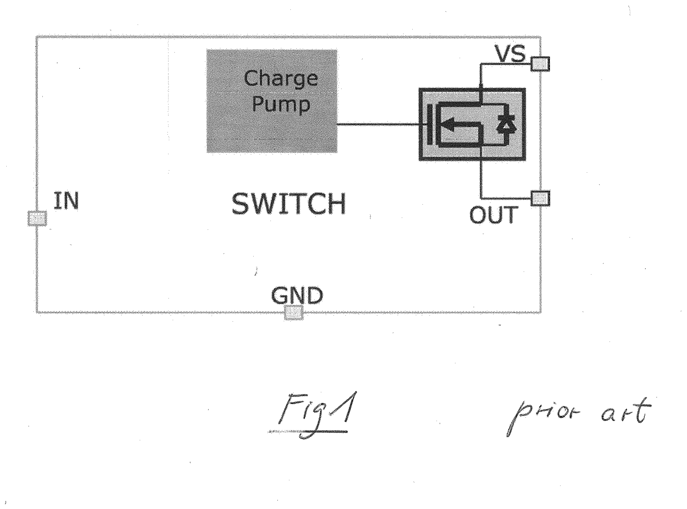

A charge pump circuit is an electronic circuit which can convert a supply voltage to a DC output voltage that can be several times higher than the supply voltage. Charge pump circuits are mostly made of capacitors and switches or diodes thereby allowing the integration on a silicon chip. A charge pump circuit uses capacitors as energy storage elements to create a voltage power source. A charge pump circuit uses switching elements to control the connection of voltages between the capacitors. A charge pump circuit can comprise several stages connected to each other via switching elements. The charge pump circuits are used in a wide range of applications. They can, for instance, be used as LCD or LED drivers generating high-bias voltages from a single low voltage supply such as a battery. Charge pump circuits can also be integrated in EEPROM and flash memory devices. Another application is the use of a charge pump circuit in a high side switch as illustrated in Fig. 1.

Fig. 1 shows a conventional intelligent power switch. These intelligent power switches or smart switches are electronic circuits that can control an electric power and are capable and rigid enough for self-protection and to protect a load and the surrounding environment. Smart switches are a modern form of relays but with intelligent protection functions implemented inside. High voltages and tens of amperes of DC currents can for instance be controlled by a vertical DMOS transistor as illustrated in Fig. 1. In automotive applications, the use of high side switches as shown in Fig. 1 is preferred. Because of a two to three times better $R_{ON}$ resistance of NMOS transistors than PMOS transistors at the same amount of area when integrated on a chip, the use of NMOS transistors as power switches is preferred over PMOS transistors. In order to fully turn on this NMOS transistor, a positive gate source voltage $V_{GS}$ is needed. Consequently, for a high side switch, a circuit is provided that generates a supply voltage being higher than the battery voltage. To generate this high voltage, a charge pump circuit is provided within the high side switch as illustrated in Fig. 1. For a low switch-on resistance $R_{ON}$, it is important to provide a charge pump circuit with a high charge pump efficiency.

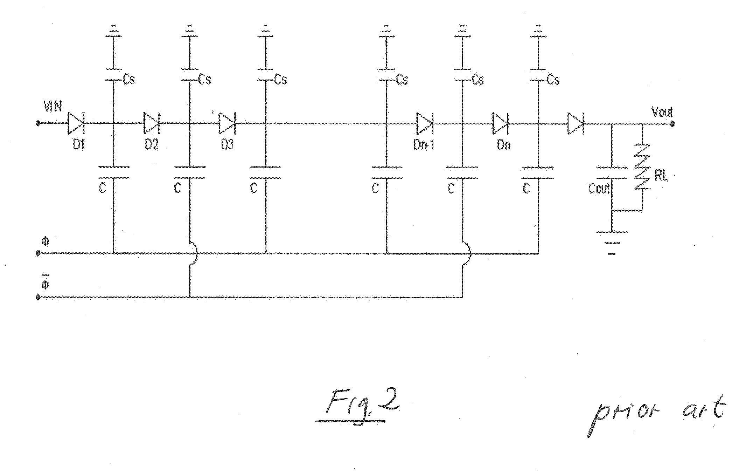

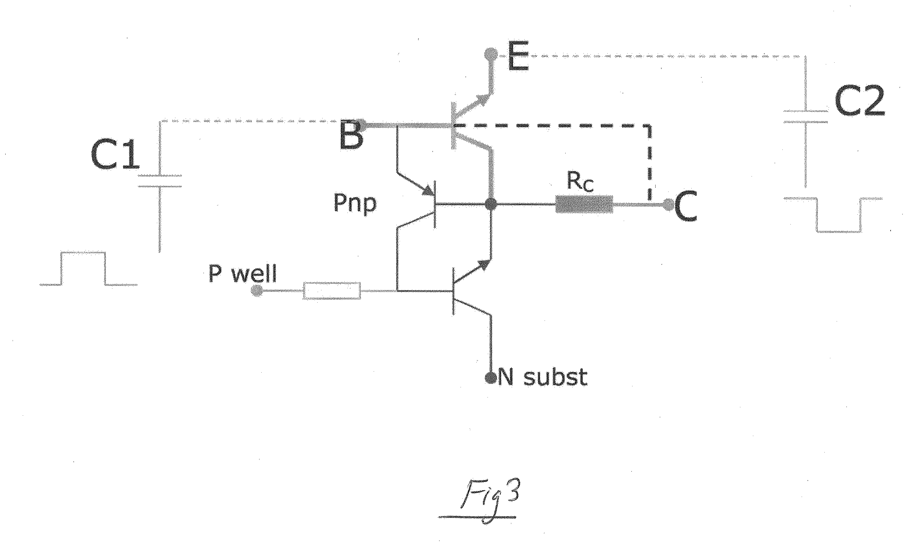

In most implementations, a Dickson charge pump circuit is used. Fig. 2 shows a circuit diagram of a conventional Dickson charge pump circuit. The Dickson charge pump circuit shown in Fig. 2 can consist of a large number of identical stages each containing a diode and a capacitor C wherein the button plates of the capacitors in consecutive stages are driven by two complementary clock signals. The electric charge is transferred from one capacitor to the next capacitor at a rhythm of the applied clock signal, thus using an output voltage that can be much higher than the input voltage applied to the diode of the first stage. It is possible that a feedback control loop is added to the circuit in order to maintain the output voltage stable and independent of system parameters or load characteristics. This can be achieved by continuously adjusting a clock frequency of the charge pump circuit. In an N substrate technology, the diode used in a conventional Dickson charge pump circuit as shown in Fig. 2 can be implemented by isolated bipolar transistors with its base and collector terminals tied together (externally) and with the parasitic devices associated to it as illustrated in Fig. 3.

The first disadvantage of this conventional implementation is the parasitic pnp transistor created. When the first capacitor C1 shown in Fig. 3 is charged and is pushed up, the bipolar diode opens and tries to transfer the electric charge from capacitor C1 to capacitor C2. Because of the parasitic resistance $R_C$, the internal collector which acts as the base of the parasitic pnp transistor, is pulled down by the main bipolar transistor and the parasitic pnp transistor opens drawing all the electric charge from capacitor C1 and injecting the charge into the P well. This makes the use of this diode implementation in a Dickson charge pump circuit critical because the charge is lost and not transferred to capacitor C2 as it is supposed to be.

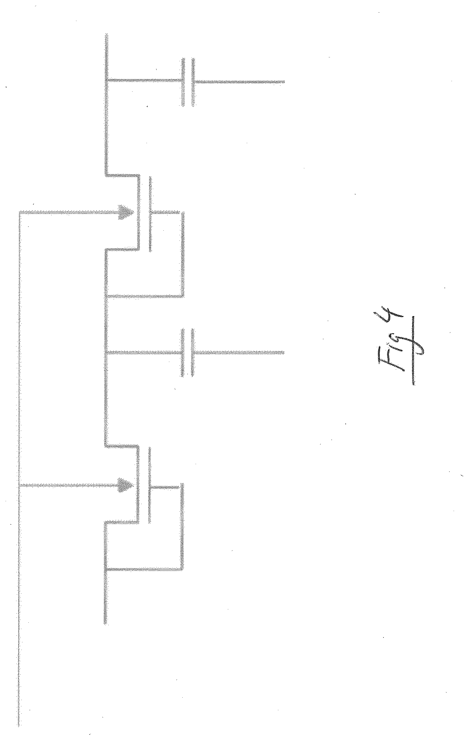

A further disadvantage of the conventional implementation shown in Fig. 3 is that a reverse breakdown voltage of the base to emitter junction makes the diode not compatible with medium and high voltage applications. Accordingly, it has been proposed to use NMOS diode connected transistors as charge transfer devices as illustrated in Fig. 4. Another disadvantage using this kind of implementation is a minimum voltage drop obtained over the diodes corresponding to the threshold voltage of these high voltage MOS transistors (i.e. about 1V). Another disadvantage of the conventional implementation shown in Fig. 4 is that the voltage drop varies due to the body effect because of the varying body to source voltage. This in turn lowers the overall charge pump efficiency of the charge pump circuit.

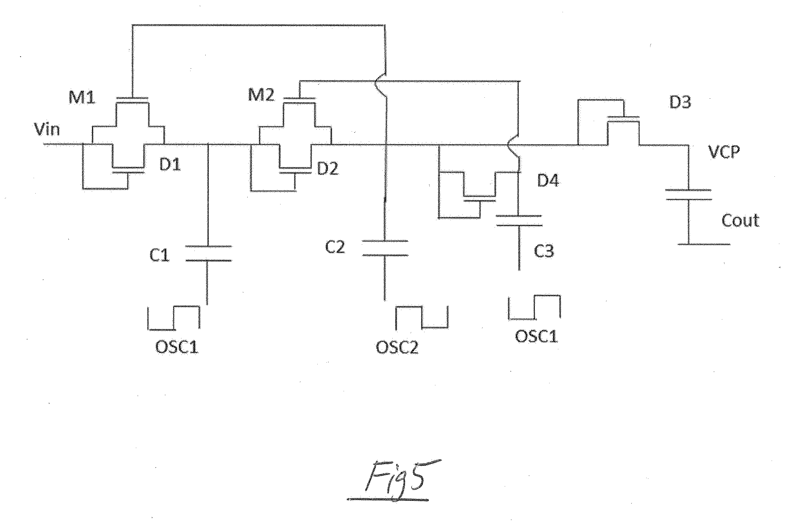

Another conventional implementation of a charge pump circuit is shown in Fig. 5. This configuration was proposed by (Jieh-Tsorng Wu, Kuen-Long Chang, "MOS Charge Pumps for Low Voltage Operation" in IEEE Journal of Solid-State Circuits, vol. 33, No. 4, April 1998. The disadvantage of this implementation is that it is only suitable for low voltage applications and needs a big area when integrated on a chip.

A charge-pump circuit without reverse current is known from document US 2009/0160532 A1. Document US 2013/0026829 A1 discloses an electronic circuit with an electronic switch and with a drive circuit for the electronic switch.

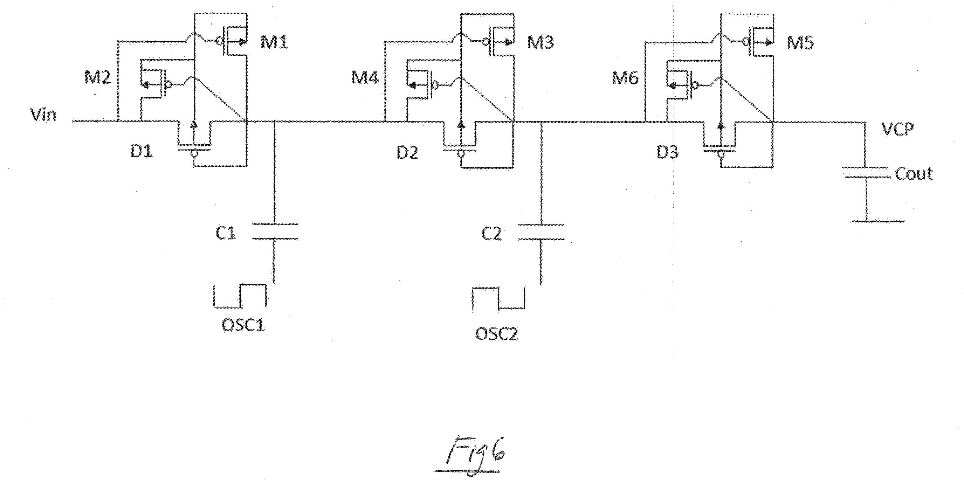

A further conventional implementation of a charge pump circuit is shown in Fig. 6. This configuration has been proposed by Jongshin Shin, In-Young Chung, Young June Park, Hong Shick Min, "A New Charge Pump without Degradation in Threshold Voltage due to Body Effect" in IEEE Journal of Solid-State Circuits, vol. 35, No. 8, August 2000. The disadvantage of this conventional implementation is that it is only compatible with low voltage technologies and also needs a big area when integrated on a chip. Further parasitic devices can disturb a correct functionality of the charge pump circuit due to bulk (substrate) switching.

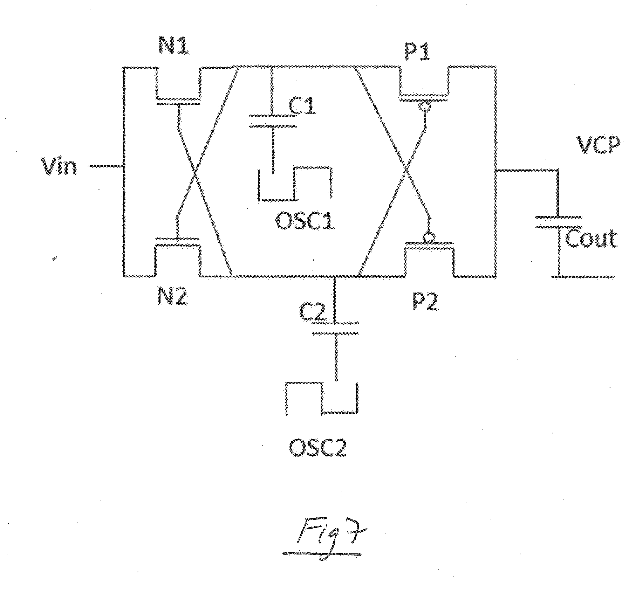

Fig. 7 shows a further conventional implementation of a charge pump circuit. This implementation has been proposed by Phang, K., Johns, D., "A 1V 1mW CMOS Front-End with On-Chip Dynamic Gate Biasing for a 75Mb/s Optical Receiver" in IEEE Int. Solid-State Circuits Conference, pp. 218-219, in February 2001. Also this conventional charge pump circuit has as a disadvantage that it is only compatible with low voltage applications. There is a need to control the bulk of the transistors. This can lead to incorrect functionality of the circuit due to parasitic devices associated.

Accordingly, it is an object of the present to provide a high side switch comprising a Dickson charge pump circuit which overcomes the above disadvantages of the conventional charge pump circuits and which provides a high charge pump efficiency.

This object is achieved by a high side switch comprising a Dickson charge pump circuit comprising the features of claim 1. Advantageous embodiments are set out in the dependent claims.

In the following, possible embodiments of the high side switch are described in more detail with reference to the enclosed figures.

Fig. 1 shows a possible application of a charge pump circuit according to the state of the art;

Fig. 2 shows a circuit diagram of a conventional Dickson charge pump circuit;

Fig. 3 shows a circuit diagram for illustrating a problem underlying the present invention;

Fig. 4 shows a circuit diagram of a conventional implementation of a charge pump circuit;

Fig. 5 shows a further circuit diagram of a conventional charge pump circuit;

Fig. 6 shows a circuit diagram of a further conventional charge pump circuit;

Fig. 7 shows a further circuit diagram of a conventional charge pump circuit;

Fig. 8 shows a simple circuit diagram for illustrating an idea underlying the present invention;

Fig. 9 shows a circuit diagram for illustrating a possible implementation of a Dickson charge pump circuit;

Fig. 10 shows a circuit diagram of a possible embodiment of a high side switch according to the present invention;

Fig. 11 shows a circuit diagram of a possible implementation of a Dickson-type charge pump circuit as used in the high side switch according to the present invention as illustrated in Fig. 10;

Fig. 12 shows a circuit diagram for illustrating the operation of a Dickson charge pump circuit;

Fig. 13 shows signal diagrams for illustrating the operation of the circuit shown in Fig. 12.

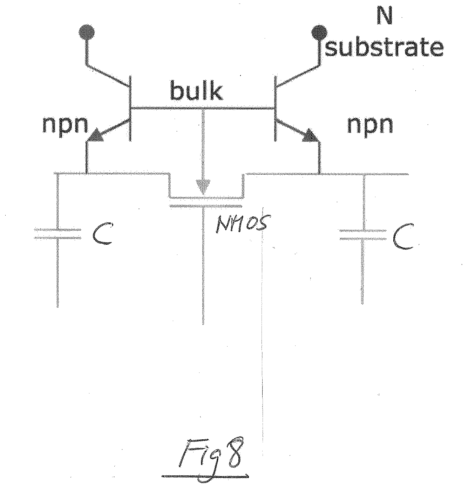

As described in the following with reference to Figs. 8 to 13, a Dickson charge pump circuit DCPC with increased efficiency is provided. Fig. 8 illustrates a basic idea underlying the present invention. The Dickson charge pump circuit DCPC has at least one serial connected pumping stage as illustrated in Fig. 8 which has a charge transfer switch adapted to transfer an electrical charge Q from an input of the pumping stage to the output of the respective pumping stage. As illustrated in Fig. 8, the charge transfer switch of the pumping stage comprises a high voltage depletion NMOS transistor having a bulk connected to a floating supply voltage being lower than an input voltage applied to the input of the pumping stage. With the Dickson charge pump circuit DCPC the above-identified problem of a pnp parasitic transistor is solved by an npn parasitic transistor associated to the high voltage depletion NMOS transistor which can be biased in such a way that this parasitic transistor is never activated, i.e. the bulk is at a lower potential than the input voltage applied to the input of the pumping stage. If, for any reason, the npn parasitic transistor shown in Fig. 8 is activated, it does not draw the electrical charge from the capacitors C but injects the charge Q into it from the N substrate. In this case, the charging of the capacitors C is done faster than without the activation of the parasitic transistor.

The output voltage of the charge pump circuit can be estimated by the following equation:

$$V_{OUT} = V_{IN} + N * (\frac{C}{C + C_S} * V_{\Phi} - V_D) - V_D - \frac{N * I_{OUT}}{(C + C_S) * f_{OSC}}$$

,

wherein $V_{IN}$ is the input voltage, $V_{OUT}$ is the output voltage,
N is the number of pumping stages,
$V_{\Phi}$ is a control voltage,
$f_{OSC}$ is the oscillation frequency,
$V_D$ is the voltage drop over the transfer switch,
C is the capacitance of a capacitor of the pumping stage, and
$I_{OUT}$ is the output current.

Accordingly, the pumping stage of the Dickson charge pump circuit DCPC shown in Fig. 8 uses as a charge transfer switch a high voltage depletion NMOS transistor which has a resistance $R_{DSON}$ which when switched on has a low voltage drop $V_D$. So by decreasing the voltage drop $V_D$ the efficiency of the Dickson charge pump circuit DCPC is increased, wherein the efficiency can be defined as $I_{OUT}$/area of the integrated circuit at a fixed output voltage $V_{OUT}$. In other words, for the same amount of area used for integration of the pumping stage mainly be occupied by the implemented capacitors C, one can draw more electrical power P from the Dickson charge pump circuit DCPC for a given output voltage $V_{OUT}$.

The Dickson charge pump circuit DCPC with increased efficiency uses a depletion NMOS transistor as a charge transfer switch. This configuration is easier to control than an implementation using for instance an enhancement NMOS transistor. By using an NMOS depletion transistor as a charge transfer switch as illustrated in Fig. 8, the technical problem of activating a parasitic transistor that discharges the capacitors instead of charging them is overcome.

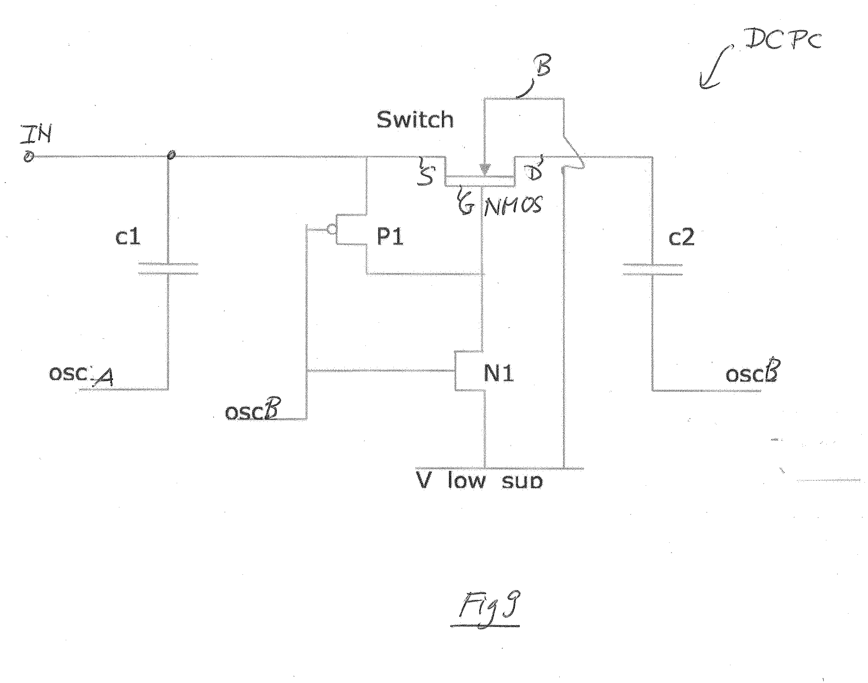

Fig. 9 shows a circuit diagram illustrating a possible implementation of a Dickson charge pump circuit DCPC. As can be seen in Fig. 9, a charge transfer switch is implemented by a high voltage depletion NMOS transistor having a source terminal S, a gate terminal G and a drain terminal D. An electrical charge Q is transferred from a first capacitor C1 via the charge transfer switch to a second capacitor C2. The bulk terminal B of the high voltage depletion NMOS transistor is connected to a floating supply voltage being lower than an input voltage applied to the input IN of the pumping stage. As can be seen in Fig. 9, the driving oscillation signals OSC generated by an oscillation signal generation circuit are applied to the charge transfer capacitors C1, C2. A PMOS transistor P1 is connected between the source terminal S and the gate terminal G of the high voltage depletion NMOS transistor of the pumping stage. Further, an NMOS transistor N1 is connected between the floating supply voltage and the gate terminal G of the high voltage depletion NMOS transistor of the pumping stage. The gate of the PMOS transistor P1 and the gate of the NMOS transistor N1 are connected to each other and receive a driving oscillation signal OSC B generated by the oscillation signal generation circuit. When the threshold of the depletion NMOS transistor forming the charge transfer switch is a negative voltage, a negative gate to source voltage is required in order to switch off the charge transfer switch. Since the threshold voltage $V_{TH}$ is negative, a zero gate source voltage $V_{GS}$ is enough to fully turn on the charge transfer switch formed by the high voltage depletion NMOS transistor. There is no need for a higher voltage. If the gate G of the high voltage depletion NMOS transistor is pulled low enough to be under the threshold voltage, the charge transfer switch turns off. This is an advantage for the Dickson charge pump circuit, because it reduces the complexity of the circuit provided to control the gate G of the charge transfer switches.

In a conventional circuit in order to turn on an NMOS transistor, a positive gate source voltage $V_{GS}$ is required. The charge transfer switch must be on when the voltage over the capacitors is high in order to transfer electrical charge Q to the next pumping stage. Consequently, in a conventional circuit one needs to assure a positive gate source voltage $V_{GS}$. This implies level shifter stages and the voltage supply is higher than the charge pump's voltage itself. Accordingly, the charge pump circuit as illustrated in Fig. 9 uses a high voltage depletion NMOS transistor to overcome these disadvantages. The only required control circuit is an inverter-like stage that turns on and off the high voltage depletion NMOS transistor. $V_{LOW-SUP}$ as illustrated in Fig. 9 is an internal floating supply voltage for the Dickson charge pump circuit. OSCA, OSCB are driving clock oscillation signals with non-overlap. If the first capacitor C1 is already charged up by the previous pumping stage, then when OSCB goes down the low voltage isolated well PMOS transistor P1 turns on and the NMOS transistor N1 turns off. The PMOS transistor P1 pulls the gate G of the high voltage depletion NMOS transistor to its source S generating a gate source voltage $V_{GS}$ of zero volts which is enough for the depletion NMOS transistor to fully turn on. When the oscillation signal OSCA goes up, it charges the second capacitor C2 in a time being equal to the time constant given by the on resistance $R_{ON}$ of the high voltage depletion NMOS transistor and the capacitance C of the capacitor C2. Accordingly, the charge transfer switch is scaled in order to fully charge the second capacitor C2 at an operating frequency of the Dickson charge pump circuit DCPC. The driving oscillation signal OSCA goes up before the driving oscillation signal OSCB in order not to discharge the second capacitor C2 through the depletion back to the first capacitor C1. When the driving oscillation signal OSCA goes down the PMOS transistor P1 turns off because the other driving oscillation signal is already down and the transistor N1 turns on assuring that the high voltage depletion NMOS transistor is off.

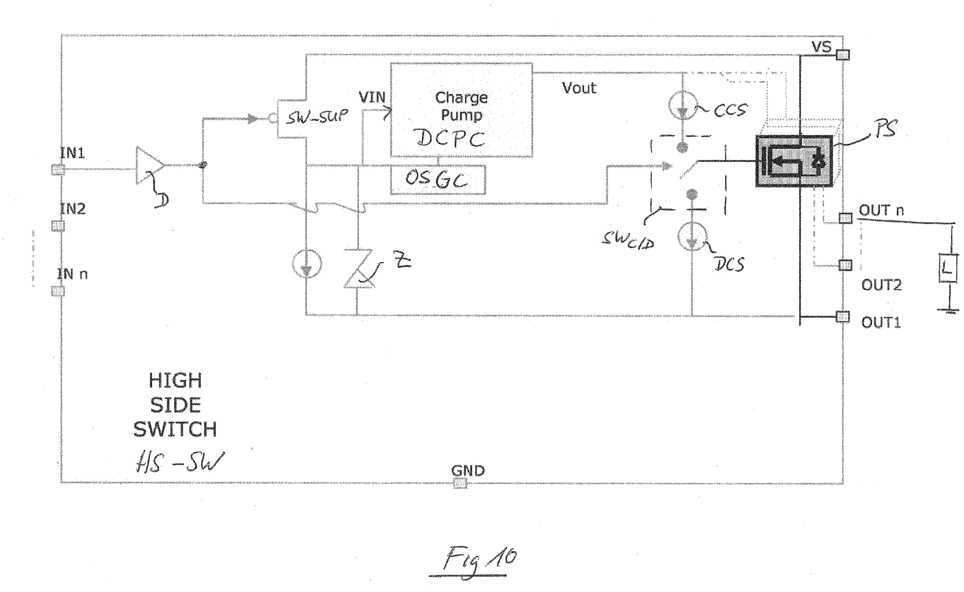

Fig. 10 shows a circuit diagram of a possible embodiment of a high side switch HS-SW comprising a Dickson charge pump circuit DCPC. An oscillation signal generation circuit OSGC generates oscillation signals which are applied to the Dickson charge pump circuit DCPC. The floating supply voltage of the Dickson charge pump circuit DCPC is clamped to the input voltage applied to the input of the first pumping stage of the Dickson charge pump circuit DCPC. The input of the first pumping stage of the Dickson charge pump circuit DCPC is switchable by means of a supply voltage switch SW-SUP to a supply voltage $V_S$ as illustrated in Fig. 10. The input of the first pumping stage of the Dickson charge pump circuit DCPC is clamped by means of a Zener diode Z to the output of a power switch PS of the high side switch HS-SW having one or several output terminals each of which can be connected to a load L. In a possible embodiment, the power switch PS of the high side switch is a DMOS transistor driving a load L. In a possible embodiment, the supply voltage $V_S$ applied to a supply voltage terminal of the high side switch HS-SW is provided by a battery. As illustrated in Fig. 10, the supply voltage switch SW-SUP is adapted to switch the Dickson charge pump circuit DCPC to the supply voltage $V_S$ being equal to the battery voltage. This supply voltage switch SW-SUP can be formed by a MOS transistor having a gate connected to a signal input of the high side switch. As shown in Fig. 10, at the input a driver circuit D can be provided having an output connected to the gate of the supply voltage switch SW-SUP. The signal input IN of the high side switch HS-SW is connected via the driver D to the gate of the supply voltage switch SW-SUP and a charging/discharging switch SW C/D being switchable between a charging current source CCS and a discharging current source DCS connected to the power switch PS as illustrated in Fig. 10. In the embodiment shown in Fig. 10, the Dickson charge pump circuit DCPC is used in a multichannel high side switch HS-SW having several outputs or channels for different loads L. Because of the increased efficiency of the Dickson charge pump circuit DCPC, the same Dickson charge pump circuit DCPC can be used as a supply for the gate driver circuits of the main power switches PS for the different channels. In this way, the area occupied by this kind of supply circuit when integrated on a chip is minimized.

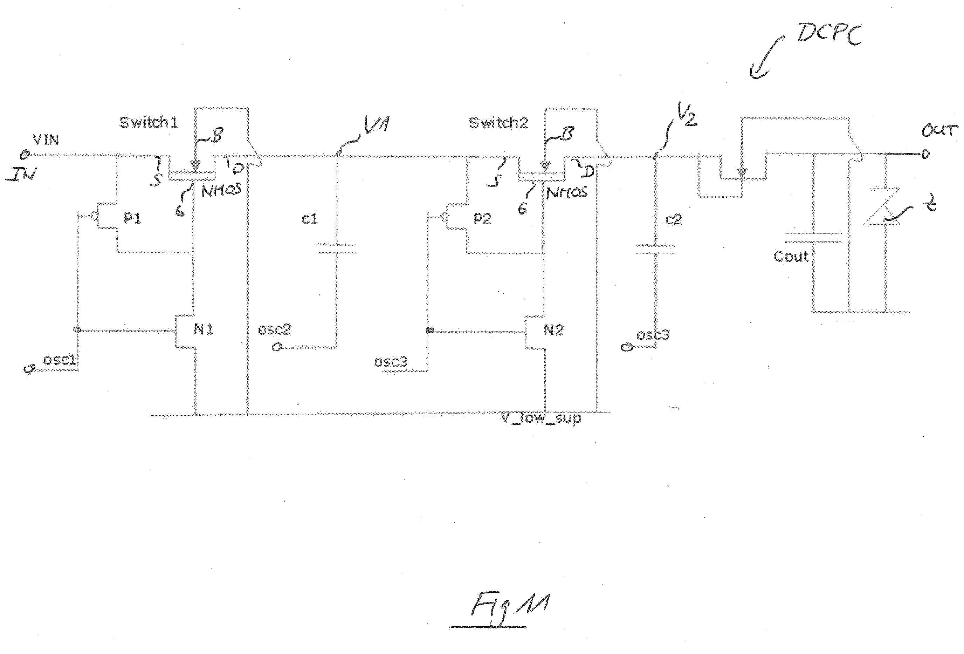

Fig. 11 shows a possible implementation of a Dickson charge pump circuit DCPC which can be used in the high side switch HS-SW as illustrated in Fig. 10. In the shown embodiment, the Dickson charge pump circuit DCPC comprises two pumping stages and an output stage. Each pumping stage comprises a charge transfer switch implemented by a high voltage depletion transistor as illustrated in Fig. 11. The bulk B of each high voltage depletion NMOS transistor is connected to a floating supply voltage V-low-sup whose potential is lower than an input voltage applied to the input of the respective pumping stage. In each pumping stage, a PMOS transistor P1 is connected between a source terminal S and the gate terminal G of the high voltage depletion NMOS transistor. Further, an NMOS transistor N1 is connected between the floating supply voltage and the gate terminal G of the high voltage depletion NMOS transistor of the respective pumping stage. The gate of the PMOS transistor P1 and the gate of the NMOS transistor N1 are connected to each other and receive a driving oscillation signal generated by the oscillation signal generation circuit OSGC. The first driving oscillation signal OSC1 is applied to the gates of the PMOS transistor P1 and the NMOS transistor N1 of the first pumping stage. The second driving oscillation signal OSC2 is applied to the capacitor C1 of the first pumping stage. A further driving oscillation signal OSC3 is applied to the gates of the PMOS transistor P2 and the NMOS transistor N2 of the second pumping stage as well as to the capacitor C2 of the second pumping stage. If the first oscillation signal OSC1 is logical high, the second driving oscillation signal OSC2 is also logical high but the third oscillation signal OSC3 is low. In a possible embodiment, the first oscillation signal OSC1 can be the same as the second driving oscillation signal OSC2. The output voltage V1 of the first pumping stage is applied as an input voltage to the second pumping stage. The output voltage V2 of the second pumping stage supplies is applied via an output switch to an output capacitor $C_{OUT}$ having a higher capacitance than the capacitors C1 and C2 of the first and second pumping stage. Parallel to the output capacitor $C_{OUT}$ a Zener Z diode can be provided.

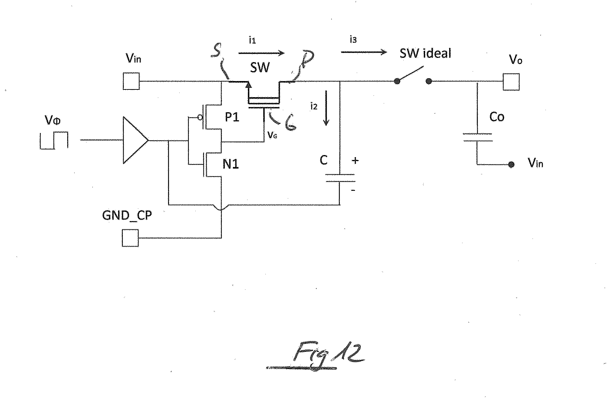

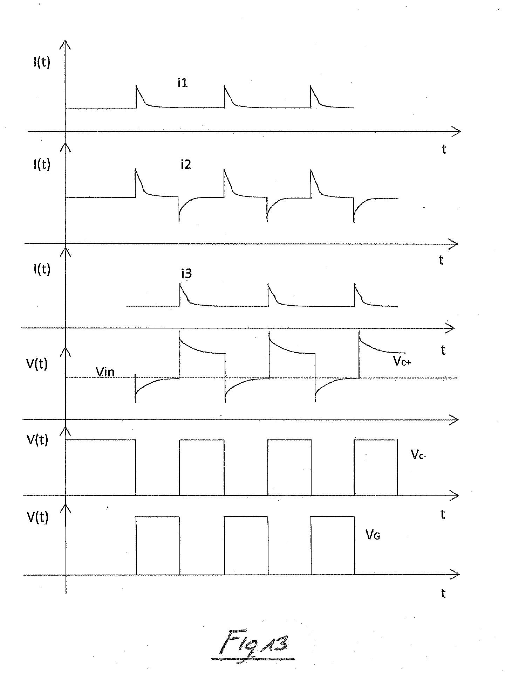

The operation of a pumping stage within the Dickson charge pump circuit DCPC according to the present invention is further illustrated with respect to the pumping stage shown in Fig. 12 and the corresponding signals illustrated in Fig. 13. As shown in Fig. 12, a charge transfer switch can be implemented by a high voltage depletion NMOS transistor whose gate G is connected to a junction node between a PMOS transistor P1 and an NMOS transistor N1. The PMOS transistor P1 is connected between the source terminal S and the gate terminal G of the high voltage depletion NMOS transistor of the pumping stage shown in Fig. 12. The NMOS transistor N1 is connected between the floating supply voltage applied at GND-CP and the gate terminal G of the high voltage depletion NMOS transistor of the pumping stage. The gate of the PMOS transistor P1 and the gate of the NMOS transistor N1 are connected to each other and receive a driving oscillation signal through a driving circuit as illustrated in Fig. 12. In the embodiment shown in Fig. 12, the driving oscillation signal applied to the gate terminals of the transistors P1, N1 is the same as the driving oscillation signal applied to the capacitor C of the respective pumping stage. Fig. 13 shows as a first signal diagram the current I1 flowing through the charge transfer switch implemented by the high voltage depletion NMOS transistor. The current I2 shown as a second diagram of Fig. 13 is the current flowing into the capacitor C of the pumping stage. The third signal diagram of Fig. 13 shows the current I3 flowing via the output of the pumping stage through an ideal switch to an output

capacitor $C_0$. Fig. 13 further shows the voltage $V_{IN}$ supplied to the input terminal IN of the pumping stage. Further, the voltage $V_{C-}$ at the negative terminal of the capacitor C is illustrated. The last signal diagram of Fig.13 shows the gate voltage VG at the gate terminal G of the high voltage depletion NMOS transistor forming the charge transfer switch.

**Claims**

1. A high side switch (HS-SW) comprising
   a power switch (PS); and
   a Dickson charge pump circuit (DCPC) configured to drive said power switch and having a pumping stage which has a charge transfer switch adapted to transfer an electrical charge from an input of the pumping stage to an output of the pumping stage,
   wherein the charge transfer switch of the pumping stage comprises a depletion NMOS transistor (NMOS) having a bulk (B) connected to a supply voltage ($V_{LOW-SUP}$) being lower than an input voltage applied to the input of the pumping stage, wherein the input of the pumping stage of said Dickson charge pump circuit (DCPC) is connected by means of a switchable supply voltage switch (SW-SUP) to a supply voltage ($V_S$) provided by a battery, and the input of the pumping stage of the Dickson charge pump circuit (DCPC) is connected by means of a Zener diode (Z) to the output of the power switch (PS) of said high side switch (HS-SW).

2. The high side switch (HS-SW) according to claim 1, wherein the pumping stage of said Dickson charge pump circuit (DCPC) comprises a charge transfer capacitor connected to the output of the pumping stage.

3. The high side switch (HS-SW) according to claim 1 or 2, wherein driving oscillation signals generated by an oscillation signal generation circuit (OSGC) are applied to the charge transfer capacitor.

4. The high side switch (HS-SW) according to one of the preceding claims 1 to 3, wherein a PMOS transistor (P1) is connected between a source terminal (S) and the gate terminal (G) of said depletion NMOS transistor of the pumping stage.

5. The high side switch (HS-SW) according to claim 4, wherein a NMOS transistor (N1) is connected between the supply voltage and the gate terminal (G) of said depletion NMOS transistor of the pumping stage.

6. The high side switch (HS-SW) according to claim 5, wherein the gate (G) of the PMOS transistor (P1) and the NMOS transistor (N1) are connected to each other and receive a further driving oscillation signal generated by the oscillation signal generation circuit (OSGC).

7. The high side switch (HS-SW) according to one of the preceding claims 1 to 6, wherein the supply voltage is connected to the input voltage applied to the input of the pumping stage of the Dickson charge pump circuit (DCPC).

8. The high side switch (HS-SW) according to one of the preceding claims 1 to 7, wherein said power switch (PS) of said high side switch (HS-SW) is a DMOS transistor driving a load (L).

9. The high side switch (HS-SW) according to one of the preceding claims 1 to 8, wherein the supply voltage switch (SW-SUP) adapted to switch said Dickson charge pump circuit (DCPC) to said supply voltage ($V_S$) is a MOS transistor having a gate connected to a signal input of said high side switch (HS-SW) which comprises said Dickson charge pump circuit (DCPC).

10. The high side switch (HS-SW) according to one of the preceding claims 1 to 9, wherein said signal input of said high side switch (HS-SW) is connected to the gate of said supply voltage switch (SW-SUP) and a charging/discharging switch (SW D/C) being switchable between a charging current source (CCS) and a discharging current source (DCS) of said power switch (PS).

11. The high side switch (HS-SW) according to one of the preceding claims 1 to 10, wherein the voltage drop ($V_D$) of the switched on depletion NMOS transistor is less than 0.7 volts.

**Patentansprüche**

1. High-Side-Schalter (HS-SW), umfassend:

einen Betriebsschalter (PS); und
eine Dickson-Ladungspumpschaltung (DCPC), die dafür ausgestaltet ist, den Betriebsschalter anzusteuern, und die eine Pumpstufe aufweist, die einen Ladungstransferschalter hat, der dafür ausgelegt ist, eine elektrische Ladung von einem Eingang der Pumpstufe zu einem Ausgang der Pumpstufe zu transferieren, wobei der Ladungstransferschalter der Pumpstufe einen Verarmungs-NMOS-Transistor (NMOS) umfasst, der ein Volumen (B) aufweist, das mit einer Versorgungsspannung ($V_{LOW-SUP}$) verbunden ist, die niedriger ist als eine Eingangsspannung, die in den Eingang der Pumpstufe eingespeist wird, wobei der Eingang der Pumpstufe der Dickson-Ladungspumpschaltung (DCPC) unter Verwendung eines schaltbaren Versorgungsspannungsschalters (SW-SUP) mit einer Versorgungsspannung ($V_S$) verbunden ist, die durch eine Batterie bereitgestellt wird, und der Eingang der Pumpstufe der Dickson-Ladungspumpschaltung (DCPC) unter Verwendung einer Zener-Diode (Z) mit dem Ausgang des Betriebsschalters (PS) des High-Side-Schalters (HS-SW) verbunden ist.

2. High-Side-Schalter (HS-SW) nach Anspruch 1, wobei die Pumpstufe der Dickson-Ladungspumpschaltung (DCPC) einen Ladungstransferskondensator umfasst, der mit dem Ausgang der Pumpstufe verbunden ist.

3. High-Side-Schalter (HS-SW) nach Anspruch 1 oder 2, wobei ansteuernde Oszillationssignale, die durch eine Oszillationssignalgenerierungsschaltung (OSGC) generiert werden, in den Ladungstransferskondensator eingespeist werden.

4. High-Side-Schalter (HS-SW) nach einem der vorangehenden Ansprüche 1 bis 3, wobei ein PMOS-Transistor (P1) zwischen einem Source-Anschluss (S) und dem Gate-Anschluss (G) des Verarmungs-NMOS-Transistors der Pumpstufe verbunden ist.

5. High-Side-Schalter (HS-SW) nach Anspruch 4, wobei ein NMOS-Transistor (N1) zwischen der Versorgungsspannung und dem Gate-Anschluss (G) des Verarmungs-NMOS-Transistors der Pumpstufe verbunden ist.

6. High-Side-Schalter (HS-SW) nach Anspruch 5, wobei das Gate (G) des PMOS-Transistors (P1) und der NMOS-Transistor (N1) miteinander verbunden sind und ein weiteres ansteuerndes Oszillationssignal empfangen, das durch die Oszillationssignalgenerierungsschaltung (OSGC) generiert wird.

7. High-Side-Schalter (HS-SW) nach einem der vorangehenden Ansprüche 1 bis 6, wobei die Versorgungsspannung mit der Eingangsspannung verbunden ist, die in den Eingang der Pumpstufe der Dickson-Ladungspumpschaltung (DCPC) eingespeist wird.

8. High-Side-Schalter (HS-SW) nach einem der vorangehenden Ansprüche 1 bis 7, wobei der Betriebsschalter (PS) des High-Side-Schalters (HS-SW) ein DMOS-Transistor ist, der eine Last ansteuert (L).

9. High-Side-Schalter (HS-SW) nach einem der vorangehenden Ansprüche 1 bis 8, wobei der Versorgungsspannungsschalter (SW-SUP), der dafür ausgelegt ist, die Dickson-Ladungspumpschaltung (DCPC) zu der Versorgungsspannung ($V_S$) umzuschalten, ein MOS-Transistor ist, dessen Gate mit einem Signaleingang des High-Side-Schalters (HS-SW) verbunden ist, der die Dickson-Ladungspumpschaltung (DCPC) umfasst.

10. High-Side-Schalter (HS-SW) nach einem der vorangehenden Ansprüche 1 bis 9, wobei der Signaleingang des High-Side-Schalters (HS-SW) mit dem Gate des Versorgungsspannungsschalters (SW-SUP) und einem Ladungs-/Entladungsschalter (SW D/C), der zwischen einer Ladestromquelle (CCS) und eine Entladestromquelle (DCS) des Betriebsschalters (PS) umgeschaltet werden kann, verbunden ist.

11. High-Side-Schalter (HS-SW) nach einem der vorangehenden Ansprüche 1 bis 10, wobei der Spannungsabfall ($V_D$) des eingeschalteten Verarmungs-NMOS-Transistors weniger als 0,7 Volt beträgt.

**Revendications**

1. Interrupteur côté haut (HS-SW) comprenant :

   un interrupteur de puissance (PS) ; et
   un circuit à pompe de charge de Dickson (DCPC) conçu pour commander ledit interrupteur de puissance et comportant un étage de pompage qui comporte un commutateur de transfert de charge conçu pour transférer une charge électrique d'une entrée de l'étage de pompage vers une sortie de l'étage de pompage,
   dans lequel le commutateur de transfert de charge de l'étage de pompage comprend un transistor NMOS à appauvrissement (NMOS) ayant un substrat (B) connecté à une tension d'alimentation ($V_{LOW-SUP}$) inférieure à une tension d'entrée appliquée à l'entrée de l'étage de pompage,
   dans lequel l'entrée de l'étage de pompage dudit circuit à pompe de charge de Dickson (DCPC) est connectée au moyen d'un commutateur de tension d'alimentation commutable (SW-SUP) à une tension d'alimentation ($V_S$) fournie par une batterie, et
   l'entrée de l'étage de pompage du circuit à pompe de charge de Dickson (DCPC) est connectée au moyen d'une diode Zener (Z) à la sortie de l'interrupteur de puissance (PS) dudit interrupteur côté haut (HS-SW).

2. Interrupteur côté haut (HS-SW) selon la revendication 1, dans lequel l'étage de pompage dudit circuit à pompe de charge de Dickson (DCPC) comprend un condensateur de transfert de charge connecté à la sortie de l'étage de pompage.

3. Interrupteur côté haut (HS-SW) selon la revendication 1 ou 2, dans lequel des signaux d'oscillation d'attaque produits par un circuit de génération de signaux d'oscillation (OSGC) sont appliqués au condensateur de transfert de charge.

4. Interrupteur côté haut (HS-SW) selon l'une des revendications 1 à 3 précédentes, dans lequel un transistor PMOS (P1) est connecté entre une borne de source (S) et la borne de grille (G) dudit transistor NMOS à appauvrissement de l'étage de pompage.

5. Interrupteur côté haut (HS-SW) selon la revendication 4, dans lequel un transistor NMOS (N1) est connecté entre la tension d'alimentation et la borne de grille (G) dudit transistor NMOS à appauvrissement de l'étage de pompage.

6. Interrupteur côté haut (HS-SW) selon la revendication 5, dans lequel la grille (G) du transistor PMOS (P1) et le transistor NMOS (N1) sont connectés entre eux et reçoivent un autre signal d'oscillation d'attaque produit par le circuit de génération de signaux d'oscillation (OSGC).

7. Interrupteur côté haut (HS-SW) selon l'une des revendications 1 à 6 précédentes, dans lequel la tension d'alimentation est connectée à la tension d'entrée appliquée à l'entrée de l'étage de pompage du circuit à pompe de charge de Dickson (DCPC).

8. Interrupteur côté haut (HS-SW) selon l'une des revendications 1 à 7 précédentes, dans lequel ledit interrupteur de puissance (PS) dudit interrupteur côté haut (HS-SW) est un transistor DMOS commandant une charge (L).

9. Interrupteur côté haut (HS-SW) selon l'une des revendications 1 à 8 précédentes, dans lequel le commutateur de tension d'alimentation (SW-SUP) conçu pour commuter ledit circuit à pompe de charge de Dickson (DCPC) sur ladite tension d'alimentation ($V_S$) est un transistor MOS ayant une grille connectée à une entrée de signaux dudit interrupteur côté haut (HS-SW) qui comprend ledit circuit à pompe de charge de Dickson (DCPC).

10. Interrupteur côté haut (HS-SW) selon l'une des revendications 1 à 9 précédentes, dans lequel ladite entrée de signaux dudit interrupteur côté haut (HS-SW) est connectée à la grille dudit commutateur de tension d'alimentation (SW-SUP) et d'un commutateur de charge/décharge (SW-D/C) commutable entre une source de courant de charge (CCS) et une source de courant de décharge (DCS) dudit interrupteur de puissance (PS).

11. Interrupteur côté haut (HS-SW) selon l'une des revendications 1 à 10 précédentes, dans lequel la chute de tension ($V_D$) du transistor NMOS à appauvrissement mis à l'état passant est inférieure à 0,7 volt.

Charge Pump

SWITCH

VS

OUT

IN

GND

prior art

Fig 1

Fig. 2

prior art

Fig 3

Fig 4

Fig 5

EP 2 775 621 B1

Fig 6

Fig 7

Fig 8

EP 2 775 621 B1

DCPc

IN

Switch

B

S      D

G NMOS

c1

P1

c2

N1

osc A

osc B

osc B

V low sup

Fig 9

VS

PS

OUT n

OUT2

OUT1

L

CCS

DCS

SW_C/D

Vout

Charge Pump
DCPC

OS_GC

VIN

SW_SUP

Z

D

IN1

IN2

IN n

HIGH SIDE SWITCH
H/S − SW

GND

Fig 10

Fig 11

EP 2 775 621 B1

Fig. 12

*Fig 13*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090160532 A1
- US 20130026829 A1

**Non-patent literature cited in the description**

- **JIEH-TSORNG WU ; KUEN-LONG CHANG.** MOS Charge Pumps for Low Voltage Operation. *IEEE Journal of Solid-State Circuits,* April 1998, vol. 33 (4
- **JONGSHIN SHIN ; IN-YOUNG CHUNG ; YOUNG JUNE PARK ; HONG SHICK MIN.** A New Charge Pump without Degradation in Threshold Voltage due to Body Effect. *IEEE Journal of Solid-State Circuits,* August 2000, vol. 35 (8
- **PHANG, K. ; JOHNS, D.** A 1V 1mW CMOS Front-End with On-Chip Dynamic Gate Biasing for a 75Mb/s Optical Receiver. *IEEE Int. Solid-State Circuits Conference,* February 2001, 218-219